# EUROPEAN PATENT SPECIFICATION

(11) **EP 2 666 184 B1**
(45) Date of publication and mention of the grant of the patent: **06.01.2021**
(21) Application number: 11797018.6
(22) Date of filing: 20.12.2011
(51) Int. Cl.: H01L 21/36, H01L 31/032

(54) **IMPROVED INTERFACE BETWEEN A I-III-VI2 MATERIAL LAYER AND A MOLYBDENUM SUBSTRATE**
VERBESSERTE GRENZFLÄCHE ZWISCHEN EINER SCHICHT AUS EINEM I-III-VI2-MATERIAL UND EINEM MOLYBDÄNSUBSTRAT
INTERFACE AMÉLIORÉE ENTRE UNE COUCHE DE MATÉRIAU À BASE D'ÉLÉMENTS DES GROUPES I-III-VI2 ET UN SUBSTRAT EN MOLYBDÈNE

(30) Priority: 27.12.2010 EP 10306519
(43) Date of publication of application: 27.11.2013
(73) Proprietor: Electricité de France, 75008 Paris (FR)
(72) Inventor: GRAND, Pierre-Philippe, F-13106 Rousset (FR); JAIME FERRER, Jesus Salvador, F-13106 Rousset (FR); ROCHE, Emmanuel, F-13106 Rousset (FR); DELIGIANNI, Hariklia, NY 10598 (US); VAIDYANATHAN, Raman, NY 10598 (US); REUTER, Kathleen B., NY 10598 (US); HUANG, Qiang, NY 10598 (US); ROMANKIW, Lubomyr, NY 10598 (US); MASON, Maurice, NY 10598 (US); ZUPANSKI-NIELSEN, Donna S., NY 12602 (US)
(74) Representative: Plasseraud IP
(86) International application number: PCT/EP2011/073401
(87) International publication number: WO 2012/089558

(56) References cited:
- WO-A1-2010/100560
- WO-A2-2007/056224
- WO-A2-2011/028957
- US-A1- 2010 255 660
- US-A1- 2010 297 835

## Description

The invention relates to the domain of manufacturing in thin layers I-III-VI compounds, for example for photovoltaic applications.

In such compounds, with stoichiometry neighboring I-III-VI₂:
- the element I from the first group of the periodic table of the elements can be copper (or also silver, or even a mixture of these elements),
- the element III from the third group can be indium, gallium, aluminum or a mixture of these elements, and
- the element VI from the sixth group can be selenium, sulfur or a mixture of these elements.

Such a compound globally has a chalcopyrite type crystallographic structure.

This compound in particular has excellent photovoltaic properties. It can be then integrated in active, thin layer form in photovoltaic cells, in particular in solar panels.

A non-expansive technique for depositing such a thin layer on large substrates (for example 30 x 60 cm²) involves often a chemical deposition and, more particularly, a deposition by electrolysis. The substrate (for example a thin layer of molybdenum on glass) needing to receive the deposition of the thin layer is provided on the surface of an electrode immersed in an electrolytic bath composing salts of element I and/or element III and/or element VI. A voltage is applied to the electrode (relative to a reference mercury sulfate electrode) to initiate the deposition.

The process for manufacturing the whole solar cell product can further include steps of deposition of additional layers (such as a transparent ZnO layer, contact layers, etc.). The solar cells based on the so-called "CIGS" material ("CIGS" for Copper (Cu), Indium (In) and/or Gallium (Ga), and Sulfur (S) and/or Selenium (Se)) include thus a substrate or back contact for the collect of the electrons generated by the photovoltaic effect. A typical substrate is composed of a glass or a metal foil, and at least one conductive layer deposited on its surface. The most common conductive layer used in the prior art is the molybdenum (Mo).

As described with more details hereafter, in an embodiment, element VI (S and/or Se) can be added to one or several layers of I-III material thanks to a heating treatment in sulfur and/or selenium atmosphere, for obtaining a layer having the desired stoichiometry I-III-VI₂. This step is called "sulfuration" or "selenization" hereafter.

One of the major issues observed in the prior art for the processes involving electrodeposition of I-III-VI₂ (or I-III) layers is the lack of adhesion between the Mo substrate and such layers. The lack of adhesion strongly decreases the electron collect at the back contact and thus reduces the performance of the solar cells.

In fact, the molybdenum substrate surface shows patchy oxide at certain locations and therefore the electroplated Cu-In-Ga (S-Se) layer on top does not adhere well in those areas where the molybdenum is oxidized.

As for example, an embodiment of the prior art for manufacturing a CuInS₂ layer can consist on:
- electrodeposing copper (Cu) on the molybdenum substrate,
- electrodeposing indium (In) on the copper layer, and
- applying a thermal annealing in order to intermix copper and indium in a same layer and to add sulfur (S) to form finally a single I-III-VI₂ homogeneous layer.

It has been observed that areas of molybdenum oxide (MoOₓ) are formed at the interface between the Mo layer and the Cu layer after the deposition of the Cu layer. More particularly, during sulfuration with H₂S gas, such areas are more likely to form copper sulfite compounds (CuₓS). A problem arising from that effect is that copper rich compounds tend to diffuse outward and migrate to the top of the chalcopyrite material, leaving behind large gaps. In such areas of voids, the copper rich sulfide compounds have diffused outwards. This can be explained by the presence of particles of copper rich compounds left behind in those areas. The voids that can be observed are called "Kirkendall voids" and occur because of the diffusion of copper away from these areas.

The migration outward diffusion of copper through indium or gallium is high, due to the fact that such materials (indium and gallium) are liquid metals during the sulfurization process.

The present invention aims to improve the situation.

To that end, the invention proposes a method as defined in claim 1 for fabricating a thin layer made of a I-III-VI alloy and having photovoltaic properties.

Therefore, the present invention proposes to create a metal layered structure and a method which, during sulfurization or selenization of the layers, will prevent the voiding at the adaptation layer (for example molybdenum)/I-III-VI₂ layer interface. Preferably, said first and second layers comprise elements I and III and the method further comprises a step of:
c) intermixing the first and second layers by a heating process, for forming advantageously an alloy I-III.

Preferably, step c) comprises an annealing operation in an atmosphere comprising at least one element VI. That kind of process is known as "sulfurization" or "selenization".

The adaptation layer preferably comprises Molybdenum (or also Platinum as a variant).

In an embodiment, the aforesaid first layer comprises Copper.

Its thickness is preferably greater than 40nm, while the adaptation layer has for example a thickness around 600nm.

Advantageously, the operation of depositing said second layer is performed in an acidic electrolysis bath. The acidity of the bath can thus corrode oxidation formed of the seed layer itself.

In an embodiment, said first and second layers comprise both Copper and Indium, and wherein the atomic ratio between the amount of Copper to Indium is thereby between 1 and 2. An advantageous stoichiometry is for example Cu₁₁In₉ as commented below. In an embodiment where a third layer is deposited on the second layer, said first, second and third layers comprise both Copper, Indium, and Gallium, and the atomic ratios between the amounts of Copper to the sum of the amounts of Indium and Gallium is thereby between 0,6 and 2.

Other characteristics and advantages of the invention will become apparent on examining the detailed description below and the attached drawings in which:
- figure 1 schematically shows an electrolytic bath to grow layers by electro-deposition,
- figure 2 schematically shows the seed layer underneath a I-III electro-deposited layer,
- figure 3 is a diagram showing resistivity properties of a copper seed layer versus its thickness,
- figure 4 shows reflectance stability versus the copper seed layer thickness,
- figure 5 shows the effect of temperature control of the substrate when exposed to air after deposition of the seed layer, on its reflectance (relative to its oxidation),
- figure 6 is a SIMS diagram (for "Secondary Ion Mass Spectroscopy") showing respective amounts of oxygen atoms in a molybdenum layer with a copper seed layer deposited on it (solid line) and without any seed layer (dashed line).

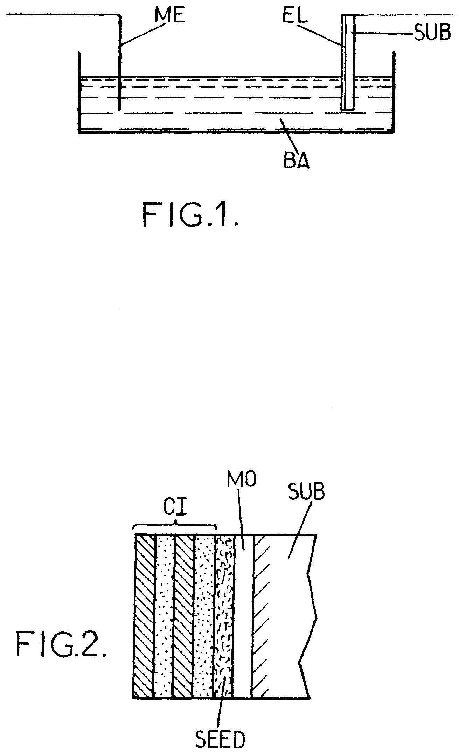

Referring to figure 1, an electrolytic bath BA may include salts of element I and/or element III and/or element VI. A voltage is applied to the electrode EL (relative to a reference mercury sulfate electrode ME) to initiate the deposition.

However, such baths are judged to be unstable because of the presence of the element VI in the bath. Thus, growing a layer of global stoichiometry neighboring I-III for example and next treating the resulting layer by subsequent supply of element VI could be considered. However, here again, the growth of the I-III layer by electrolysis could turn out to be unstable and in particular the control of the stoichiometry of the I-III alloy in the final layer is not assured.

It is therefore currently preferred to deposit a multilayer structure according to a sequence of elementary layers (for example a layer of element I, then a layer of element III, and then optionally a new layer of element I and a layer of element III, etc.), and then apply a thermal treatment (typically annealing according to a selected sequence of raising, holding and lowering temperature) to obtain an "intermixed" structure, therefore mixed, of global I-III stoichiometry.

The element VI can be supplied subsequently (by thermal treatment of selenization and/or sulfuration) or at the same time as the aforementioned annealing to obtain the desired I-III-VI₂ stoichiometry.

The resulting layers have satisfactory photovoltaic properties by providing thereby good yields of photovoltaic cells incorporating such thin layers.

More particularly, referring now to figure 2, such I-III layers are deposited on an adaptation layer Mo between the substrate SUB and the I-III layers CI. The adaptation layer is generally made of a stable metallic material such as molybdenum.

In order to prevent oxidation of the adaptation layer (Mo) and to promote adhesion of the future I-III-VI layer on it, the invention proposes to deposit a thin Cu, In or Ga "seed" layer or "strike" layer (referred as "SEED" on figure 2), on top of the adaptation layer Mo (made of molybdenum or of an alloy comprising that element for example). This seed layer is deposited under vacuum or near vacuum conditions (for example by physical deposition technique (for example by spraying a target under very low pressure) or any equivalent technique).

Both the adaptation layer Mo and the seed layer SEED are deposited in "vacuum" conditions and in particular without exposure to air.

After that step, other possible I-III layers (referred as CI layers on figure 2) are deposited by electrolysis on the seed layer (which is electrically conductive since Cu, In and Ga are conductive metals).

In order to ensure a robust interface between the seed layer and the other I-III layers, an acid plating chemistry including salts of copper and/or indium and/or gallium and/or any other I, III material, is preferably used on top of the seed layer to etch possible oxide stains located on the top surface of the seed layer. It is worth noting here that most of the existing Cu, In, Ga electrolytic solutions for electrolysis are acid. Tests have been carried out with a copper layer as a seed layer deposited on a molybdenum layer.

A robust Mo/Cu interface is satisfactory to prevent Kirkendall voiding but in order to further improve the interface morphology, a ratio between elements I and III is to be optimized. For example, copper (Cu) left over at the Mo/Cu interface shall be controlled. It has been identified more particularly that a minimum amount of Cu required to react with indium (In) and to form a Cu11In9 layer contributes to improve adhesion on Mo.

In order to slow down the diffusion of Cu in the element III liquid (In or Ga) during sulfurization, an alternate fabrication process is proposed here, where a first binary alloy of Culn2 is first electroplated and than converted into a second alloy Cu11In9 (and/or CuGa2 if the first alloy includes Ga). This second alloy is then sulfurized (or selenized) in order to form a sulfurized CuInS2 (or selenized CuInSe2) chalcopyrite structure.

It should be noted that CuInGaS(or Se) I-III-VI material can be obtained by electroplating a Culn2 alloy on a Mo/Cu interface followed by the electroplating of a CuGa2 alloy.

### Examples of embodiments

By using electrochemistry, copper/indium/gallium deposits show high purity and large grain structure especially after soft annealing. The Cu and In grain structures can be matched resulting in a large grain structure for the chalcopyrite material.

In order to prevent oxidation of molybdenum (Mo) and to promote adhesion of Mo and CuInGaSeS, a thin Cu or In seed layer is deposited on top of the Mo in a vacuum system. Both the Mo and the seed are deposited in vacuum without exposure to air, for example by using a technique of deposition such as vapor phase deposition (or "PVD").

Samples with 600nm Mo tensile stress and 40nm Cu seed on soda lime glass have been fabricated. The cells with tensile Mo showed no loss of adhesion and 9-10% efficiency.

Substrates (soda lime glasses) are preferably prepared prior to PVD deposition with a washer using detergent solution and multiple steps brushes. Glass is dried with an ultra pure air flow. This contamination control prevents from possible surface defects which lead to pinholes during dry deposition step.

For industrial compatibility and process stability, it has been observed that the thicker the Cu seed layer is and the better the control of the electrical parameters of the complete glass/Mo/Cu stack is, and specially regarding the sheet resistance uniformity for large substrates.

The molybdenum layer is made of several molybdenum sub-layers done with same or different PVD process conditions (power, gas ratio). A specific resistivity is to be optimized to ensure film stability and further CIGS or CIGSSe layers stability.

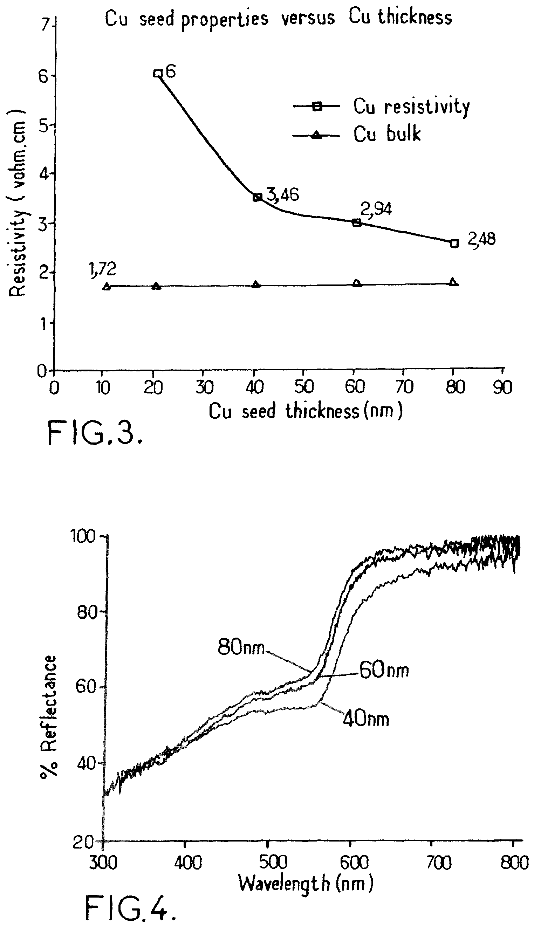

The minimum Cu seed thickness is set at 74nm which is twice as the electron mean path in copper. Below this value, a strong increase of the resistivity of the copper seed layer is observed. With reference to figure 3, for a slight variation of the thickness across the substrate during coating (usual coaters having a non-uniformity of 3 to 5% across the substrate), the variation of resistance sheet can be lowered by a thicker copper seed layer.

With a thickness of 80nm, the uniformity of the sheet resistance of the Mo/Cu back contact is found to be better than 5%. In that case, the Mo/Cu stack can be below a specific resistivity (for example 12uOhm.cm) if the Mo layer thickness is around 600nm, providing thus abilities for growing I-III layers by electro-deposition.

Figure 4 shows that oxidation of the copper layer is lower with a thickness of 60 or 80nm instead of 40nm. In fact, the oxidation is detected by the brightness variation of the layer. The diagram of figure 4 shows that reflectance is higher after 20 minutes of exposure to atmosphere (at a temperature of 21°C, with relative humidity of 45%).

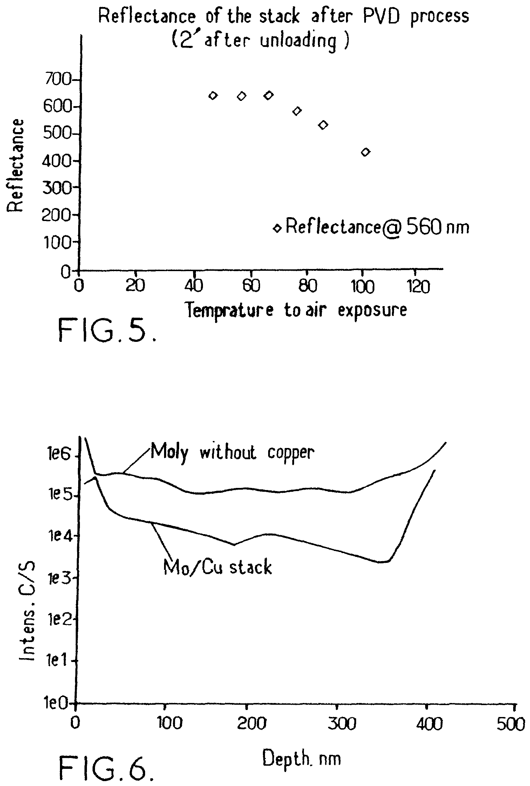

It has been observed also that Mo/Cu stack is very sensitive to exposure to atmosphere when hot. The temperature of the substrate when exposed to air after sputtering process during unload step has an implication on the reflectance measured on the Mo/Cu layer at a wavelength of 560nm. More particularly, as a general rule, coated substrates should not see atmosphere preferably at temperature above 70°C, as shown on figure 5.

Figure 6 is a SIMS analysis diagram of:
- a Mo layer deposited by PVD (dashed line),
- a stack of Mo layer (deposited by PVD), underneath a copper layer deposited by PVD (solid line).

It shows that the oxygen in the Mo/Cu(PVD) structure is captured by copper rather than by Mo. The Mo/Cu(PVD) seed interface is almost free of oxygen. Alternatively, Mo/Cu(electrolysis) layer has a lot of oxygen at the Cu interface exposed to air. More particularly:
- Mo layer of the Mo/Cu(PVD) stack has about 20 times less oxygen than the Mo layer,
- the Cu (PVD) capping layer on Mo has about 50 times less oxygen content than in the normal Mo layer.

Therefore, Cu capping layer protects the Mo layer from oxidation. Cu oxide can be easily removed by an acidic pH solution which can be provided by most of preexisting electrolysis baths.

Finally, the reduced amount of oxygen atoms (i.e. oxidation) found at the interface between the adaptation layer (Mo) and the I-III-VI compound at the end of its fabrication is an evidence of the implementation of the process according to the invention.

Therefore, the invention aims also at an electroplated I-III-VI compound layer deposited on a substrate through an adaptation layer, wherein the adaptation layer and at least one layer comprising at least elements I and III are deposited under near vacuum conditions without exposing to air said adaptation layer, and, more particularly, wherein oxidation is reduced at the interface between the adaptation layer and the I-III-VI compound layer by a factor of at least 10, compared to a structure of an electroplated I-III-VI compound layer deposited on an adaptation layer without depositing said layer comprising at least elements I and III under near vacuum conditions.

The invention aims also at a solar cell device comprising such an electroplated I-III-VI compound layer.

More particularly, it has been observed that the adhesion between the adaptation layer and the I-III-VI compound layer passes the ISO-2409 test (vendor reference 99C8705000 test). Moreover, the interface between the I-III-VI compound layer and the adaptation layer is almost free from void.

The effect of such features is an improvement of the surface conductivity of the formed structure.

### Examples of embodiment

### Example 1: Glass/ 600nm Mo / Cu 40nm (under vacuum)/ Cu citrate (electrolysis) / In sulfate (electrolysis) / Cu citrate (electrolysis) / In sulfate (electrolysis)

The Cu citrate layer is electroplated while stirring a paddle cell in the electrolysis bath, with a current density of 5 mA /cm2 during 51 seconds for growing a layer having a thickness of 110 nm. The In sulfate layers are electroplated with a current density of 0,5 mA/cm2 during 1000 seconds for growing 200 nm thick layers (at 70% efficiency). The second citrate Cu layer is electroplated during 70 seconds and its thickness is 150nm.

### Example 2: Glass/600nm Mo/ 40nm Cu (under vacuum)/Cu Shipley® electrolytic solution (Layer 1) / In sulfate (Layer 2) / Cu Shipley® electrolytic solution (Layer 3) / In sulfate (Layer 4)

Layer 1: Cu Shipley 3001 chemistry, 15 mA/cm², 21 seconds (110 nm thick)
Layer 2: In sulfate, 0,5 mA/cm², 1000 sec (200 nm thick at 70% efficiency), Pt anode,
Layer 3: Cu Shipley 3001 chemistry, 15 mA/cm², 28 sec (150 nm thick)
Layer 4: In sulfate, 0,5 mA/cm², 1000 sec (200 nm thick at 70% efficiency), Pt anode.

Example 2 is preferred to Example 1 because large grain structure of the electroplated Cu layers from the Shipley 3001 chemistry is matched with the indium chemistry, resulting in large grains in the chalcopyrite layer. Moreover, the acidity of the Shipley 3001 copper bath prevents the surface of the Cu layer deposited under vacuum from oxidation.

### Example 3: Glass/600nm Mo/ 80nm Cu (under vacuum)/ Cu Enthone® (Layer 1) / In Enthone® (Layer 2)

Layer 1: Cu Microfab SC chemistry, 15 mA/cm², 120 sec (340 nm)
Layer 2: In Heliofab 390, 15 mA/cm², 180 sec (450 nm at 70% efficiency)

Example 3 is a preferred embodiment because of the efficient thickness of the copper seed layer, preventing from oxidation the interface with molybdenum, according to an advantage of the present invention. Moreover, the acidity of the Microfab SC copper bath prevents the surface of the Cu layer deposited under vacuum from oxidation.

### Example 4: Glass/600nm Mo/ 80nm Cu (under vacuum)/ Cu Enthone® (Layer 1) / In Enthone® (Layer 2) / Ga Enthone® (Layer 3)

Layer 1: Cu Microfab SC chemistry, 10 mA/cm2, 25 sec (70 nm)
Layer 2: In Heliofab 390, 20 mA/cm2, 60 sec (380 nm)
Layer 3: Ga Heliofab 365, 20 mA/cm2, 15 sec (160 nm)

Example 4 introduces Gallium as a different element III from Indium.

In these examples of embodiment, the terms "Cu (under vacuum)" relate to copper deposition under "near vacuum conditions". Such conditions aim a monitoring of possible contamination by residual oxygen, water, etc. of the copper layer during its deposition by sputtering. The pressure in the sputtering chambers may be limited to a range between 1.10⁻⁷ and 5.10⁻⁶ mbar. During the sputtering process itself (of molybdenum or copper), the pressure can be higher, for example in a range form 1 to 10 µbar.

It should be understood more generally that the deposition of the molybdenum adaptation layer is performed under near vacuum conditions (within an extended range between 1.10⁻⁷ mbar and 10 µbar, e.g. between 10⁻¹⁰ bar and 10⁻⁵ bar) and followed by the copper layer deposition in similar conditions, and more particularly without exposure to air between the two layer depositions.

The thickness of the seed layer can be chosen according to the mean free path of the material chosen for the seed layer.

As for examples, the seed layer can be formed of an elemental layer (a pure Copper layer, or a pure Indium layer), or also of an alloy layer such as Culn, CuGa, CuInGa, or InGa.

However, more generally, the seed layer comprises "at least" elements I and/or III. Therefore, it can include another element. For example, it can include Molybdenum (Mo). More particularly, the seed layer can comprise alloys such as MoCu, Moln, or MoGa.

Moreover, the electroplated elements I and/or III can be deposited as a single I-III layer. For example, salts of element I and element III can be provided in a same electrolysis bath.

The substrate on which the adaptation layer is deposited can be either a glass (soda lime) substrate or a metallic substrate such as a steel sheet for example.

Moreover, the invention applies to any adaptation layer metal that oxidizes in air (e.g. Molybdenum or any other metal).

## Claims

1. A method for fabricating a thin layer made of a I-III-VI alloy and having photovoltaic properties,
element I being Copper, element III being Indium and/or Gallium and element VI being Sulfur and/or Selenium,
the method comprising first steps of:
a) depositing an adaptation layer on a substrate,
b) depositing at least one layer comprising at least elements I and/or III, on said adaptation layer,
wherein said adaptation layer is deposited under near vacuum conditions within a range between 10⁻¹⁰ bar and 10⁻⁵ bar, step b) comprises a first operation of depositing a first layer of I and/or III elements, under same conditions as the deposition of the adaptation layer, without exposing to air said adaptation layer, said adaptation layer and said first layer being deposited by sputtering and/or evaporation in a same machine, and wherein step b) comprises a second operation of depositing at least one second layer of I and/ or III elements, by electrolysis.

2. The method of claim 1, wherein said first and second layers comprise elements I and III and the method further comprises a step of:
c) intermixing the first and second layers by a heating process.

3. The method of claim 2, wherein said step c) comprises an annealing operation in an atmosphere comprising at least one element VI.

4. The method of anyone of claims 1 to 3, wherein said adaptation layer comprises Molybdenum.

5. The method of anyone of claims 1 to 4, wherein said first layer comprises Copper.

6. The method of claim 5, wherein said first layer has a thickness greater than 40nm.

7. The method of anyone of claims 4 to 6, wherein the adaptation layer has a thickness of 600nm.

8. The method of claim 1, wherein the second operation of depositing said second layer is performed in an acidic electrolysis bath.

9. The method of anyone of claims 1 to 8, wherein said first and second layers comprise both Copper and Indium, and wherein the atomic ratio between the amount of Copper to Indium is thereby between 1 and 2.

10. The method of anyone of claims 1 to 8, comprising further the deposition of a third layer on the second layer, wherein said first, second and third layers comprise each Copper, Indium, and Gallium, and wherein the atomic ratios between the amounts of Copper to the sum of the amounts of Indium and Gallium is thereby between 0,6 and 2.

## Patentansprüche

1. Verfahren zur Herstellung einer aus einer I-III-VI-Legierung hergestellten Dünnschicht, die fotoelektrische Eigenschaften hat,
wobei das Element I Kupfer ist, das Element III Indium und/oder Gallium ist und das Element VI Schwefel und/oder Selen ist,
wobei das Verfahren die folgenden ersten Schritte aufweist:
a) Abscheiden einer Anpassungsschicht auf einem Substrat,
b) Abscheiden wenigstens einer Schicht, die wenigstens die Elemente I und/ oder III aufweist, auf der Anpassungsschicht,
wobei die Anpassungsschicht nahezu unter Vakuumbedingungen innerhalb eines Bereichs zwischen 10⁻¹⁰ und 10⁻⁵ bar abgeschieden wird, wobei der Schritt b) einen ersten Arbeitsschritt zur Abscheidung einer ersten Schicht aus I- und/oder III-Elementen unter den gleichen Bedingungen wir der Abscheidung der Anpassungsschicht aufweist, ohne die Anpassungsschicht Luft auszusetzen, wobei die Anpassungsschicht und die erste Schicht durch Zerstäuben und/oder Verdampfen in einer gleichen Vorrichtung abgeschieden werden, und wobei der Schritt b) einen zweiten Arbeitsschritt zum Abscheiden wenigstens einer zweiten Schicht aus I- und/oder III-Elementen durch Elektrolyse aufweist.

2. Verfahren nach Anspruch 1, wobei die erste und zweite Schicht Elemente I und III aufweisen und das Verfahren ferner einen folgenden Schritt aufweist:
c) Vermischen der ersten und zweiten Schichten durch ein Erwärmungsverfahren.

3. Verfahren nach Anspruch 2, wobei der Schritt c) einen Temperschritt in einer Atmosphäre, die wenigstens ein Element VI aufweist, aufweist.

4. Verfahren nach einem der Ansprüche 1 bis 3, wobei die Anpassungsschicht Molybdän aufweist.

5. Verfahren nach einem der Ansprüche 1 bis 4, wobei die erste Schicht Kupfer aufweist.

6. Verfahren nach Anspruch 5, wobei die erste Schicht eine Dicke hat, die größer als 40 nm ist.

7. Verfahren nach einem der Ansprüche 4 bis 6, wobei die Anpassungsschicht eine Dicke von 600 nm hat.

8. Verfahren nach Anspruch 1, wobei der zweite Arbeitsschritt zum Abscheiden der zweiten Schicht in einem säurehaltigen Elektrolysebad durchgeführt wird.

9. Verfahren nach einem der Ansprüche 1 bis 8, wobei die erste und zweite Schicht sowohl Kupfer als auch Indium aufweisen und wobei das Atomverhältnis zwischen der Menge von Kupfer und Indium hierbei zwischen 1 und 2 liegt.

10. Verfahren nach einem der Ansprüche 1 bis 8, das ferner die Abscheidung einer dritten Schicht auf der zweiten Schicht aufweist, wobei die erste, zweite und dritte Schicht jeweils Kupfer, Indium und Gallium aufweisen,
und wobei die Atomverhältnisse zwischen den Mengen von Kupfer und der Summe der Mengen von Indium und Gallium hierbei zwischen 0,6 und 2 liegen.

## Revendications

1. Procédé de fabrication d'une couche mince constituée d'un alliage I-III-VI et ayant des propriétés photovoltaïques,
l'élément I étant le cuivre, l'élément III étant l'indium et/ou le gallium et l'élément VI étant le soufre et/ou le sélénium,
le procédé comprenant les premières étapes de :
a) dépôt d'une couche d'adaptation sur un substrat,
b) dépôt d'au moins une couche comprenant au moins les éléments I et/ou III, sur ladite couche d'adaptation,
dans lequel ladite couche d'adaptation est déposée dans des conditions de quasi-vide dans une plage entre 10⁻¹⁰ bar et 10⁻⁵ bar, l'étape b) comprend une première opération de dépôt d'une première couche d'éléments I et/ou III, dans les mêmes conditions que le dépôt de la couche d'adaptation, sans exposition à l'air de ladite couche d'adaptation, ladite couche d'adaptation et ladite première couche étant déposées par pulvérisation cathodique et/ou évaporation dans une même machine, et dans lequel l'étape b) comprend une deuxième opération de dépôt d'au moins une deuxième couche d'éléments I et/ou III, par électrolyse.

2. Procédé selon la revendication 1, dans lequel lesdites première et deuxième couches comprennent les éléments I et/ou III et le procédé comprend en outre une étape de :
c) mélange entre elles des première et deuxième couches par un processus de chauffage.

3. Procédé selon la revendication 2, dans lequel ladite étape c) comprend une opération de recuit dans une atmosphère comprenant au moins un élément VI.

4. Procédé selon l'une quelconque des revendications 1 à 3, dans lequel ladite couche d'adaptation comprend du molybdène.

5. Procédé selon l'une quelconque des revendications 1 à 4, dans lequel ladite première couche comprend du cuivre.

6. Procédé selon la revendication 5, dans lequel ladite première couche a une épaisseur supérieure à 40 nm.

7. Procédé selon l'une quelconque des revendications 4 à 6, dans lequel la couche d'adaptation a une épaisseur de 600 nm.

8. Procédé selon la revendication 1, dans lequel la deuxième opération de dépôt de ladite deuxième couche est réalisée dans un bain d'électrolyse acide.

9. Procédé selon l'une quelconque des revendications 1 à 8, dans lequel lesdites première et deuxième couches comprennent à la fois du cuivre et de l'indium, et dans lequel le rapport atomique entre la quantité de cuivre et la quantité d'indium est ainsi entre 1 et 2.

10. Procédé selon l'une quelconque des revendications 1 à 8, comprenant en outre le dépôt d'une troisième couche sur la deuxième couche, dans lequel lesdites première, deuxième et troisième couches comprennent chacune du cuivre, de l'indium et du gallium,
et dans lequel les rapports atomiques entre les quantités de cuivre et la somme des quantités d'indium et de gallium sont ainsi entre 0,6 et 2.
